# EUROPÄISCHE PATENTANMELDUNG

(11) **EP 4 524 296 A1**
(43) Veröffentlichungstag der Anmeldung: **19.03.2025**
(21) Anmeldenummer: 23197282.9
(22) Anmeldetag: 13.09.2023
(51) Int. Cl.: C30B 15/00, C30B 15/36, C30B 29/06, C30B 33/00

(54) **VERFAHREN ZUM ZIEHEN EINES EINKRISTALLSTABS**

(71) Anmelder: Siltronic AG, 81677 München (DE)
(72) Erfinder: Dorner, Alicia, 84489 Burghausen (DE); Knerer, Dieter, 84533 Haiming (DE); Stockmeier, Ludwig, 01187 Dresden (DE); Zemke, Dirk, 5122 Ach (AT)
(74) Vertreter: Grundner, Sebastian

(57) **Zusammenfassung**

Verfahren zum Ziehen eines Einkristallstabs aus einer Siliziumschmelze gemäß der Czochralski-Methode, umfassend die folgenden Schritte:
(i) Bereitstellen einer Siliziumschmelze und eines Impfkristalls aus einkristallinem Silizium über der Siliziumschmelze, wobei die Siliziumschmelze und/oder der Impfkristall optional Dotierstoffe umfassen;
(ii) Absenken des Impfkristalls, bis ein Kontakt zwischen dem Impfkristall und der Siliziumschmelze hergestellt ist; und
(iii) Ziehen eines Impflingskonus, eines Dünnhalses, eines Anfangskonus und eines zylindrischen Abschnitts des Einkristallstabs in dieser Reihenfolge durch Anheben des Impfkristalls;
dadurch gekennzeichnet, dass der Impflingskonus einen oberen Durchmesser von nicht weniger als 12 mm und nicht mehr als 22 mm, einen unteren Durchmesser von nicht weniger als 2 mm und nicht mehr als 10 mm, und eine axiale Länge von nicht weniger als 75 mm und nicht mehr als 300 mm aufweist.

## Beschreibung

### Technisches Gebiet

Gegenstand der vorliegenden Erfindung ist ein Verfahren zum Ziehen eines Einkristallstabs, ein Verfahren zur Herstellung von Scheiben aus Halbleitermaterial, und eine Scheibe aus einkristallinem Silizium.

### Stand der Technik

Einkristalline Scheiben aus Halbleitermaterial (auch Wafer genannt) sind die Grundlage der modernen Elektronik. Sie werden in einer Vielzahl von Prozessschritten hergestellt, die das Ziehen eines Einkristallstabs aus einer Schmelze, das Schleifen und Sägen des Kristalls in Scheiben, und die Oberflächenbearbeitung der Scheiben umfassen.

Einkristalline Scheiben aus Halbleitermaterial, insbesondere Halbleiterscheiben aus Silizium, werden üblicherweise hergestellt, indem zuerst ein monokristalliner Stab gemäß dem sogenannten Czochralski-Verfahren (CZ) gezogen wird. Die so produzierten Stäbe werden mittels dafür geeigneter Sägen wie Drahtsägen, Innenlochsägen oder Bandsägen in Kristallstücke geteilt, welche dann üblicherweise in einer Drahtsäge oder Innenlochsäge zu Halbleiterscheiben verarbeitet werden. Nach weiteren mechanischen, chemo-mechanischen und/oder chemischen Schritten kann auf der Scheibe optional eine Schicht mittels chemischer Gasphasenabscheidung ("Chemical Vapor Deposition", CVD) abgeschieden werden.

Das CZ-Verfahren erfolgt üblicherweise durch Absenken eines gewöhnlich als Impfling bezeichneten Impfkristalls hin zu einer Siliziumschmelze mit einer Temperatur von über 1410°C, bis ein Kontakt mit der Siliziumschmelze hergestellt wurde. Das Kristallwachstum erfolgt, indem der Impfkristall langsam unter Drehung wieder nach oben gezogen wird, während die Schmelze an der sich ausbildenden Grenzfläche erstarrt. Dabei wird zunächst ein Anfangskonus des Einkristalls mit zunehmendem Durchmesser, darauffolgend ein zylindrischer Abschnitt mit dem gewünschten Durchmesser, und schließlich ein Endkonus mit abnehmendem Durchmesser gezogen.

Wenn der Impfkristall in Kontakt mit der heißen Siliziumschmelze gebracht wird, treten im Impfkristall Spannungen auf, die zur Ausbildung von Versetzungen im Impfkristall führen. Diese Versetzungen können sich über die gesamte Länge des Kristallstabs fortsetzen.

Diese Versetzungen können in den meisten Fällen durch die Ausbildung eines Dünnhalses aus dem Einkristall entfernt werden. Um einen auch als Dash-Neck bezeichneten Dünnhals auszubilden, wird der rotierende Impfkristall mit hoher Geschwindigkeit nach oben gezogen, um den Durchmesser des im Wesentlichen zylindrischen Dünnhalses auf üblicherweise 2 bis 6 mm zu verringern. Ausgehend von dem versetzungsfreien Dünnhals wird der Durchmesser des Einkristallstabs wieder erhöht und es kann ein versetzungsfreier Einkristall mit dem gewünschten Durchmesser gezogen werden. Dieses Verfahren wird auch als Dash-Methode oder Dash-Neck-Methode bezeichnet.

Stufenversetzungen können im Allgemeinen durch die Dash-Neck-Methode vermieden werden. Für Schraubenversetzungen gilt dies nicht im gleichen Maße. Diese können nicht immer mit der Dash-Neck-Methode entfernt werden.

So beschreibt die EP 1 498 517 A1, dass bei einem Impfling mit der Kristallorientierung <110> Versetzungen im Zentrum des Impflings nicht einfach mit der Dash-Neck-Methode entfernt werden können. Bei einem Impfling mit einer <110>-Kristallorientierung, wenn also die Ziehrichtung des Kristalls senkrecht zur Kristallebene mit einem Miller'schen Index von (110) verläuft, können beim Eintauchen des Impflings in die Schmelze Gleitversetzungen im Zentrum entstehen, die sich in axialer Richtung, also entlang der Ziehrichtung des Einkristallstabs, über die gesamte Länge des Stabs fortsetzen. Auch bei einer Kristallorientierung von <100> treten bei einem Teil der gezogenen Einkristallstäbe selbst dann Versetzungen auf, wenn die Dash-Neck-Methode angewandt wird. Die EP 1 498 517 A1 beschreibt ein Verfahren zum Ziehen eines Einkristallstabs, in dem die Entstehung von Versetzungen im Impfling verhindert wird. Somit müssen keine Versetzungen entfernt werden und das Verfahren kommt deshalb ohne die Dash-Neck-Methode aus.

Die EP 1 498 516 B1 beschreibt ein Verfahren zur Herstellung eines Siliziumeinkristalls mit der Kristallorientierung <110>, wobei Versetzungen im Impfling dadurch entfernt werden, dass der Impfkristall relativ zur axialen Ziehrichtung um einen vorbestimmten Winkel geneigt wird, so dass die Ziehrichtung nicht genau senkrecht zur Kristallebene mit einem Miller'schen Index von (110) erfolgt. Durch anschließendes Ausbilden eines Dünnhalses gemäß der Dash-Neck-Methode können die Versetzungen entfernt werden. Jedoch können aus einem gemäß der EP 1 498 516 B1 hergestellten Einkristallstab keine Halbleiterscheiben mit einer genau parallel zur Kristallebene <110> verlaufenden Oberfläche hergestellt werden, was die Eignung dieser Halbleiterscheiben für anspruchsvolle elektrische Bauelemente mit hoher Schaltfrequenz begrenzt.

Die US 4 002 523 A beschreibt ein komplexes Verfahren zum Ziehen eines Einkristallstabs mit einer Kristallorientierung <110>, in der ein Dünnhals mit abwechselnd dünnen und dicken Bereichen gezogen wird, wodurch Versetzungen, die parallel zur Wachstumsrichtung (Ziehrichtung) des Einkristalls verlaufen, allmählich von der Achse des Kristalls weg und an die Peripherie verschoben werden. Dadurch steigt die Wahrscheinlichkeit, dass die Versetzungen an einer Oberfläche enden und somit aus dem Kristall verschwinden. Jedoch ist in diesem aufwendigen und komplexen Verfahren eine Verjüngung des Dünnhalses auf 2,5 mm erforderlich, so dass die Stabilität des Dünnhalses verringert und damit die Kristallentnahme von großen Kristallstäben erschwert ist.

JP 9 255 490 A2 schlägt außerdem vor, bei der Herstellung von Bor-dotierten Siliziumeinkristallen einen Impfling und eine Schmelze mit gleicher Borkonzentration zu verwenden, und dadurch die Ausbildung von Versetzungen zu verhindern, die durch unterschiedliche Gitterkonstanten hervorgerufen werden.

JP 2982053 B2 beschreibt ein Verfahren zum Ziehen eines Einkristalls, das ebenfalls ohne die Dash-Neck-Methode auskommt. In diesem Verfahren wird der Impfling knapp über die Schmelze abgesenkt und dort erwärmt, danach ein Teil des Impflings (Impfkristalls) mit einer Rate von 0,05 bis 2 mm/min in die Schmelze eingetaucht und anschließend der eingetauchte Teil des Impflings aufgeschmolzen. Dabei weist der eingetauchte Teil eine Länge in vertikaler Richtung auf, die mindestens dem Durchmesser des Impflings entspricht. Durch das Aufschmelzen wird unter anderem der Teil des Impfkristalls, der durch thermische Spannungen entstandene Versetzungen aufweist, geschmolzen. Der Teil des Impflings, der nach dem Aufschmelzen übrigbleibt, weist somit keine Defekte mehr auf.

Die oben beschriebenen Verfahren sind allesamt relativ aufwendig und ineffizient und damit nur eingeschränkt in der Industrieproduktion einsetzbar. Zudem sind diese Verfahren nur unzureichend dazu geeignet, einen Einkristallstab mit der Kristallorientierung <110>, der frei von zentrumsnahen Defekten ist, herzustellen.

### Technische Aufgabe der Erfindung und deren Lösung

Der vorliegenden Erfindung liegt die Aufgabe zugrunde, ein effizientes Verfahren zum Ziehen eines Einkristallstabs aus Halbleitermaterial ohne zentrumsnahe Defekte gemäß der Czochralski-Methode bereitzustellen. Insbesondere ist es Ziel der vorliegenden Erfindung, ein effizientes Verfahren bereitzustellen, dass dazu geeignet ist, einen versetzungsfreien Einkristallstab aus Halbleitermaterial mit der Kristallorientierung <100>, <110> oder <111 > bereitzustellen.

Der Erfindung liegt dabei die überraschende Beobachtung zugrunde, dass nach dem Eintauchen des Impflings durch das Ziehen eines Impflingskonus einer bestimmten Geometrie unter bestimmten Bedingungen ein Einkristallstab mit der Kristallorientierung <110> hergestellt werden kann, der frei von zentrumsnahen Defekten, insbesondere frei von zentrumsnahen Schraubenversetzungen, ist.

Gelöst wird diese Aufgabe gemäß dem ersten Aspekt der vorliegenden Erfindung durch das erfindungsgemäße Verfahren zum Ziehen eines Einkristallstabs aus einer Siliziumschmelze nach der Czochralski-Methode. Das Verfahren umfasst die folgenden Schritte:
(i) Bereitstellen einer Siliziumschmelze und eines Impfkristalls aus einkristallinem Silizium über der Siliziumschmelze, wobei die Siliziumschmelze und/oder der Impfkristall optional Dotierstoffe umfassen;
(ii) Absenken des Impfkristalls, bis ein Kontakt zwischen dem Impfkristall und der Siliziumschmelze hergestellt ist; und
(iii) Ziehen eines Impflingskonus, eines Dünnhalses, eines Anfangskonus und eines zylindrischen Abschnitts des Einkristallstabs in dieser Reihenfolge durch Anheben des Impfkristalls;
dadurch gekennzeichnet, dass der Impflingskonus einen oberen Durchmesser von nicht weniger als 12 mm und nicht mehr als 22 mm, einen unteren Durchmesser von nicht weniger als 2 mm und nicht mehr als 10 mm, und eine axiale Länge von nicht weniger als 75 mm und nicht mehr als 300 mm aufweist.

Bevorzugte Ausführungsformen des erfindungsgemäßen Verfahrens gemäß dem ersten Aspekt sind Gegenstand der abhängigen Ansprüche 2 bis 10.

Es wurde überraschend festgestellt, dass mit dem erfindungsgemäßen Verfahren ein Einkristallstab mit der Kristallorientierung <110> hergestellt werden kann, der frei von zentrumsnahen Defekten, insbesondere frei von zentrumsnahen Schraubenversetzungen, ist. Außerdem ist das erfindungsgemäße Verfahren aufgrund der überraschend hohen Geschwindigkeiten, mit denen der Impfkristall vor dem Beginn des Kristallziehens bewegt werden kann, da keine Haltephasen erforderlich sind, besonders effizient und damit wirtschaftlich.

Zentrumsnahe Defekte sind Linearkombinationen aus verschiedenen Versetzungen, beispielsweise aus mehreren Schraubenversetzungen und/oder Stufenversetzungen, die durch Knicke, die auch als Kinks bezeichnet werden, verbunden sind. Zentrumsnahe Defekte entstehen beim Kontakt des Impflings (Impfkristalls) mit der Schmelze und propagieren durch den Dünnhals. Um durch den Dünnhals propagieren zu können, müssen sich solche Defekte durch das Zentrum des Impfkristalls über den Dünnhals hinweg zum Zentrum des wachsenden Einkristallstabes fortsetzen. Deshalb treten sie im obersten Teil des zylindrischen Abschnittes des Einkristalls, und damit in den aus dem obersten Teil des zylindrischen Abschnittes erhaltenen Scheiben mit dem gewünschten Nenndurchmesser, im Zentrum oder zumindest zentrumsnah auf. Eine mögliche Abweichung der Ziehrichtung von der gewünschten Kristallorientierung führt dazu, dass sich die Versetzungen mit zunehmender Länge des wachsenden Einkristalls vom Zentrum wegbewegen. Mit zunehmender Entfernung vom Dünnhals können sich die durch den Einkristallstab propagierenden Versetzungen also immer weiter vom Zentrum des wachsenden Einkristallstabes entfernen. Eine zentrumsnahe Versetzung im Sinne der vorliegenden Erfindung ist eine Versetzung, die bis zu 50 mm vom Zentrum der Halbleiterscheibe, also vom Scheibenmittelpunkt, entfernt auftritt. Ein Einkristallstab gilt als versetzungsfrei im Sinne der vorliegenden Erfindung, wenn eine Scheibe aus dem obersten Teil des zylindrischen Abschnittes, insbesondere aus dem obersten 10 cm des zylindrischen Abschnitts des Einkristallstabes, keine zentrumsnahen Versetzungen aufweist.

Gemäß dem zweiten Aspekt ist die vorliegende Erfindung auf ein Verfahren zur Herstellung von Scheiben aus Halbleitermaterial gerichtet. Dieses Verfahren umfasst die folgenden Schritte:
Ziehen eines Einkristallstabs nach dem Verfahren gemäß dem ersten Aspekt,
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben.

In einer bevorzugten Ausführungsform des erfindungsgemäßen Verfahrens gemäß dem zweiten Aspekt umfasst das Verfahren zusätzlich den Schritt der Abscheidung einer epitaktischen Schicht aus Halbleitermaterial auf der Scheibe aus Halbleitermaterial.

Gemäß dem dritten Aspekt betrifft die vorliegende Erfindung eine Scheibe aus einkristallinem Silizium, wobei
die Scheibe einen Nenndurchmesser von 300 mm hat und die Kristallorientierung der Hauptflächen nicht mehr als 5° von der Orientierung <110> abweicht,
die Scheibe optional Dotierstoffe enthält, und
die Scheibe keine Versetzungen im Umkreis von 50 mm um den Scheibenmittelpunkt herum aufweist,
wobei die Untersuchung der Scheibe auf Versetzungen gemäß der folgenden Methode erfolgt:
   Platzieren der glanzgeätzten oder polierten Scheibe auf einem Rotationstisch in einem Transmissions-Dunkelfeld-Polariskop,
   Versetzten der Scheibe auf dem Rotationstisch in Rotation,
   Durchstrahlen der rotierenden Halbleiterscheibe auf dem Rotationstisch mit einem linear polarisierten Infrarot-Lichtstrahl, während die Halbleiterscheibe kontinuierlich oder diskontinuierlich in radialer Richtung verschoben wird,
   Bestimmung der ortsabhängigen Depolarisation und Transmission, und
   Identifizierung der Stellen, an denen der Lichtstrahl depolarisiert wird als Versetzungen.

### Kurzbeschreibung der Figuren

**Fig. 1** zeigt die gemessene Depolarisationsverteilung einer gemäß dem Ausführungsbeispiel hegestellten Scheibe und zeigt, dass diese Scheibe frei von zentrumsnahen Defekten war.
**Fig. 2** zeigt die gemessene Depolarisationsverteilung einer gemäß dem Vergleichsbeispiel hegestellten Scheibe, die zentrumsnahe Defekte aufwies.

### Detaillierte Beschreibung der Erfindung

Im erfindungsgemäßen Verfahren gemäß dem ersten Aspekt wird zunächst im Schritt (i) eine Siliziumschmelze und ein Impfkristalls aus einkristallinem Silizium über der Siliziumschmelze bereitgestellt. Die Begriffe Impfkristall und Impfling werden synonym verwendet. Der Impfkristall ist vorzugsweise rotationssymmetrisch und wird so über der Siliziumschmelze angeordnet, dass seine Rotationsachse vertikal, also entlang der Ziehrichtung, ausgerichtet ist. Die Rotationsachse ist also parallel zur Ziehrichtung angeordnet. Besonders bevorzugt ist der Impfkristall zylindrisch und seine Zylinderachse parallel zur Ziehrichtung ausgerichtet.

Der Impfkristall hat vorzugsweise einen Durchmesser von nicht weniger als 5 mm und nicht mehr als 25 mm. In einer besonders bevorzugten Ausführungsform hat der Impfkristall einen Durchmesser von nicht weniger als 14 mm und nicht mehr als 22 mm. Die axiale Länge des Impfkristalls entspricht vorzugsweise mindestens dem dreifachen Durchmesser, besonders bevorzugt mindestens dem vierfachen Durchmesser, und am meisten bevorzugt mindestens dem fünffachen Durchmesser des Impfkristalls. Vorzugsweise entspricht die axiale Länge des Impfkristalls, die aus der Halterung des Impfkristalls nach unten herausragt mindestens dem dreifachen, besonders bevorzugt mindestens dem vierfachen Durchmesser des Impfkristalls (vor dem Eintauchen, also bevor ein Kontakt zwischen dem Impfkristalls und der Siliziumschmelze hergestellt wurde). Die Halterung ist dabei ein Element am unteren Ende der Ziehwelle oder des Seils, das zur Fixierung des oberen Teils des Impfkristalls an der Ziehwelle oder am Seil dient.

Die Siliziumschmelze und der Impfkristall bestehen im Wesentlichen aus Silizium. In einer bevorzugten Ausführungsform beträgt der Anteil von Silizium in der Schmelze und im Impfkristall jeweils nicht weniger als 99,0 Gew.-%, besonders bevorzugt jeweils nicht weniger als 99,8 Gew.-%, und am meisten bevorzugt jeweils nicht weniger als 99,9 Gew.-%. Die Siliziumkonzentration in der Schmelze und im Impfkristall können unabhängig voneinander variiert werden.

Die Siliziumschmelze und/oder der Impfkristall können dabei optional Dotierstoffe, beispielsweise des p-Typs und/oder des n-Typs, enthalten. Der Dotierstoff ist beispielsweise mindestens ein Element ausgewählt aus Bor, Aluminium, Gallium, Indium, Kohlenstoff, Germanium, Stickstoff, Phosphor, Arsen, Antimon und Sauerstoff. Der Impfkristall hat vorzugsweise eine Dotierstoffkonzentration von weniger als 10¹⁵ Atomen pro cm³. Die Siliziumschmelze hat vorzugsweise eine Dotierstoffkonzentration von weniger als 10¹⁵ Atomen pro cm³. Die Dotierstoffkonzentration ist dabei die Summe der Konzentrationen der Dotierstoffe B, Al, Ga, In, C, Ge, Sn, Pb, N, P, As, Sb, Bi und O.

Die Siliziumschmelze hat dabei eine Temperatur von nicht weniger 1410°C, vorzugsweise nicht weniger als 1420°C. Der Schmelzpunkt einer Siliziumschmelze liegt bei ca. 1410°C. In einer Ausführungsform ist die Schmelze überhitzt. Dies bedeutet, dass die Temperatur der Schmelze höher als ihr Schmelzpunkt ist.

Im Schritt (ii) erfolgt das Absenken des Impfkristalls, bis ein Kontakt zwischen dem Impfkristall und der Siliziumschmelze hergestellt ist. Der Kontakt im Sinne der vorliegenden Erfindung kann mindestens einer ausgewählt aus einer Berührung, einem thermischen Kontakt und einem elektrischen Kontakt zwischen der Unterseite des Impfkristalls und der Oberfläche der Schmelze sein. Dabei kann auch ein Teil des Impfkristalls in die Siliziumschmelze eingetaucht werden. Vorzugsweise wird der Impfkristall nicht mehr als 5 mm, besonders bevorzugt nicht mehr als 2 mm, in die Siliziumschmelze eingetaucht. Der Impfkristall kann dabei an einer Ziehwelle oder einem Seil befestigt werden, mittels derer er in vertikaler Richtung entlang der Ziehachse nach unten bewegt und mit der Schmelze in Kontakt gebracht werden kann.

Das Absenken und In-Kontakt-Bringen des Impfkristalls mit der Schmelze im Schritt (ii) erfolgt vorzugsweise mit einer Geschwindigkeit von nicht mehr als 30 mm/min, vorzugsweise mit einer Geschwindigkeit von nicht weniger als 5 mm/min und nicht mehr als 20 mm/min. Eine Absenkung des Impfkristalls mit dieser Geschwindigkeit ermöglicht es, das Auftreten von thermischen Spannungen im Impfkristall während des Absenkens zu verringern, und so die Ausbildung und Ausbreitung von Versetzungen zu reduzieren.

Der Impfkristalls ist entlang der Ziehrichtung ausgerichtet. Die Rotationsachse des, vorzugsweise rotationssymmetrischen, Impfkristalls verläuft also in vertikaler Richtung. Demensprechend verläuft die Zylinderachse eines besonders bevorzugten zylindrischen Impfkristalls in vertikaler Richtung. Der Impfkristall hat vorzugsweise eine <100>-Kristallorientierung, eine <110>-Kristallorientierung oder eine <111>-Kristallorientierung. Bei einer <100>- Kristallorientierung verläuft die Kristallebene mit einem Miller'schen Index von (100) senkrecht zur Ziehrichtung, und damit bei einem zylindrischen Impfkristall senkrecht zur Zylinderachse des Impfkristalls. Entsprechend verläuft bei einem Impfkristall mit einer <110>-Kristallorientierung die Zylinderachse und die Ziehrichtung senkrecht zur Kristallebene mit einem Miller'schen Index von (110). Die gewünschte Kristallorientierung im Sinne der vorliegenden Erfindung liegt auch dann vor, wenn der Winkel zwischen der senkrecht zur Ziehrichtung verlaufenden Ebene und der Ebene mit der gewünschten Kristallorientierung nicht mehr als 5° beträgt. Dies bedeutet, dass eine senkrecht zur Kristallebene mit der gewünschten Orientierung, beispielsweise einer <100>-Kristallorientierung, einer <110>-Kristallorientierung, oder einer <111>-Kristallorientierung, angeordnete Achse bis zu 5° von der Orientierung der Ziehachse, also der Ziehrichtung, abweichen kann. Vorzugsweise weicht die Ziehrichtung von der gewünschten Kristallorientierung nicht mehr als 4° ab, besonders bevorzugt nicht mehr als 3°, am meisten bevorzugt nicht mehr als 2°. Vorzugsweise weicht die Ziehrichtung nicht mehr als 2° von einer <100>-Kristallorientierung oder einer <110>-Kristallorientierung ab. Somit beträgt in dieser Ausführungsform der Winkel zwischen der Ziehrichtung und der senkrecht zur Kristallebene mit einem Miller'schen Index von (100) oder (110) stehenden Achse maximal 2°. In einer weiteren besonders bevorzugten Ausführungsform weicht die Ziehrichtung von der gewünschten Kristallorientierung nicht mehr als 1,5° ab.

Nach dem Absenken und In-Kontakt-Bringen des Impfkristalls mit der Siliziumschmelze kann im Schritt (iii) des erfindungsgemäßen Verfahrens gemäß dem ersten Aspekt das Ziehen eines Einkristallstabs aus der Schmelze durch Anheben des Impfkristalls erfolgen. Dabei werden ein Impflingskonus, ein Dünnhals, ein Anfangskonus und ein zylindrischer Abschnitt des Einkristallstabs in dieser Reihenfolge gezogen. Ein Impflingskonus im Sinne der vorliegenden Erfindung ist ein Abschnitt des wachsenden Einkristalls, der sich nach unten hin verjüngt und der vorzugsweise die Form eines Kegelstumpfes hat. Der obere Durchmesser entspricht dabei vorzugsweise dem größten Durchmesser und der untere Durchmesser dem kleinsten Durchmesser des kegelstumpfförmigen Abschnittes.

Wenn ein Kontakt zwischen dem Impfkristall und der Siliziumschmelze hergestellt ist, und der gegebenenfalls eingetauchte Teil des Impfkristalls geschmolzen ist, bildet sich eine homogene Grenzschicht zwischen der Schmelze und dem festen Teil des Impfkristalls aus. Im Schritt (iii) kann dann die Ziehwelle oder das Seil, an welchen der Impfkristall befestigt ist, langsam unter Drehung nach oben gezogen werden, während die Siliziumschmelze an der sich ausbildenden Grenzfläche erstarrt. Durch Variation von Ziehgeschwindigkeit, Rotationsgeschwindigkeit und Temperatur erreicht der wachsende, rotierende Kristallstab den jeweils gewünschten Durchmesser. Mittels einer geeigneten Regelung kann der Durchmesser des Kristallstabs sehr genau eingestellt werden.

Zunächst erfolgt im Schritt (iii) das Ziehen eines Impflingskonus, wobei der Impflingskonus einen oberen Durchmesser von nicht weniger als 12 mm und nicht mehr als 22 mm, einen unteren Durchmesser von nicht weniger als 2 und nicht mehr als 10 mm, und eine axiale Länge von nicht weniger als 75 mm und nicht mehr als 300 mm aufweist. Der Impflingskonus verjüngt sich also nach unten. Vorzugsweise hat der Impflingskonus eine Länge von nicht weniger als 150 und nicht mehr als 225 mm, einen oberen Durchmesser von nicht weniger als 14 und nicht mehr als 20 mm, und einen unteren Durchmesser von nicht weniger als 4 und nicht mehr als 6 mm. Der obere Durchmesser des Impflingskonus entspricht dabei vorzugsweis dem Durchmesser des Impfkristalls bevor ein Kontakt zwischen dem Impfkristall und der Siliziumschmelze hergestellt wurde. Der Winkel zwischen einer Mantellinie des Impflingskonus und der Rotationsachse des Impflingskonus beträgt vorzugsweise nicht weniger als 2° und nicht mehr als 15°, besonders bevorzugt nicht weniger als 4° und nicht mehr als 13°. Durch das Ziehen eines Impflingskonus mit der beschriebenen Geometrie können zentrumsnahe Versetzungen, insbesondere Schraubenversetzungen, aus dem Einkristallstab entfernt werden. Der Impflingskonus hat vorzugsweise die Form eines Kegelstumpfes. Der Durchmesser des Impflingskonus nimmt also während des Ziehens des Kristallstabes vorzugsweise gleichmäßig mit zunehmender Länge ab, bis der untere Durchmesser des Impflingskonus erreicht wird und ein Dünnhals gezogen wird. Vorzugsweise beträgt die Tiegelrotation während des Ziehens 5 bis 20 Umdrehungen pro Minute, besonders bevorzugt 10 bis 15 Umdrehungen pro Minute.

Im Anschluss an das Ziehen des Impflingskonus wird ein Dünnhals gezogen, wobei der Durchmesser des Dünnhalses den unteren Durchmesser des Impflingskonus nicht überschreitet. Vorzugsweise hat der Dünnhals einen Durchmesser von nicht weniger als 2 und nicht mehr als 10 mm, besonders bevorzugt nicht weniger als 4 und nicht mehr als 6 mm. In einer bevorzugten Ausführungsform entspricht der Durchmesser des Dünnhalses dem unteren Durchmesser des Impflingskonus. Vorzugsweise hat der Dünnhals eine Länge von nicht weniger als 100 mm, besonders bevorzugt nicht weniger als 200 mm und nicht mehr als 600 mm.

Im Anschluss an das Ziehen des Dünnhalses wird ein Anfangskonus gezogen. Dazu wird der Durchmesser des wachsenden Einkristallstabs kontinuierlich erhöht, bis der gewünschte Durchmesser des Einkristallstabs erreicht ist.

Der gewünschte Durchmesser des Einkristallstabs hängt dabei vom gewünschten Nenndurchmesser der Scheiben, die aus dem Einkristallstab hergestellt werden sollen, ab. Da sich in der Fertigung von Scheiben durch mechanische Verarbeitungsschritte wie Schleifen der Durchmesser verringert, ist der gewünschte Durchmesser des Einkristallstabs größer als der Nenndurchmesser. Vorzugsweise liegt der gewünschte Durchmesser des Einkristallstabs nicht weniger als 1 mm und nicht mehr als 20 mm, vorzugsweise nicht weniger als 2 mm und nicht mehr als 10 mm, über dem Nenndurchmesser der herzustellenden Scheiben aus Halbleitermaterial.

Der Abschnitt mit dem gewünschten Durchmesser des Einkristallstabs wird auch als zylindrischer Abschnitt des Einkristallstabs bezeichnet. In diesem Abschnitt liegt der Durchmesser in jeder Position entlang der axialen Richtung, also entlang der Ziehrichtung, im Bereich des gewünschten Durchmessers. Somit ist der zylindrische Abschnitt des Einkristalls der Abschnitt, in dem der Durchmesser in jeder Position entlang der axialen Richtung größer als der Nenndurchmesser der herzustellenden Scheiben aus Halbleitermaterial ist. Vorzugsweise liegt der Durchmesser im zylindrischen Abschnitt in jeder Position entlang der axialen Richtung nicht weniger als 1 mm und nicht mehr als 20 mm, besonders bevorzugt nicht weniger als 2 mm und nicht mehr als 10 mm, über dem Nenndurchmesser der herzustellenden Scheiben aus Halbleitermaterial. Der zylindrische Abschnitt des Einkristallstabs ist somit der Abschnitt des Einkristallstabs, der für die Herstellung von Scheiben mit dem gewünschten Nenndurchmesser geeignet ist.

Der Durchmesser des zylindrischen Abschnittes kann über die axiale Länge dieses Abschnitts variieren, solange der Durchmesser an jeder Stelle mindestens 1 mm über dem gewünschten Nenndurchmesser der herzustellenden Scheiben aus Halbleitermaterial liegt. In einer besonders bevorzugten Ausführungsform variiert der Durchmesser des zylindrischen Abschnitts über die axiale Länge des zylindrischen Abschnittes um weniger als 20 mm, vorzugsweise um weniger als 10 mm, wobei die Variation der Differenz aus dem größten und dem geringsten Durchmessers über die axiale Länge entspricht.

Der Nenndurchmesser beträgt vorzugsweise nicht weniger 150 mm und nicht mehr als 300 mm, besonders bevorzugt nicht weniger als 200 mm und nicht mehr als 300 mm, am meisten bevorzugt 300 mm. Ein Scheibe hat den gewünschten Nenndurchmesser, wenn ihr tatsächlicher Durchmesser nicht mehr als 5 mm, vorzugsweise nicht mehr als 3 mm, besonders bevorzugt nicht mehr als 1 mm, von dem im Nenndurchmesser aufgeführten Wert abweicht.

Nachdem der zylindrische Abschnitt des Einkristallstabs mit dem gewünschten Durchmesser gezogen wurde, kann ein Endkonus gezogen und der Kristallstab entnommen werden.

Im Schritt (iii) liegt die Ziehgeschwindigkeit vorzugsweise im Bereich von 0,5 bis 10 mm/min, besonders bevorzugt 2 bis 6 mm/min. Die Rotationsgeschwindigkeit des Kristalls liegt vorzugsweise im Bereich von 1 bis 20 Umdrehungen pro Minute, besonders bevorzugt 5 bis 15 Umdrehungen pro Minute.

Die Temperatur der Siliziumschmelze während des Schrittes (iii) ist vorzugsweise nicht weniger als 1410°C, mehr bevorzugt nicht weniger als 1420°C und am meisten bevorzugt nicht weniger als 1425°C. Die Temperatur bei Ziehbeginn ist vorzugsweise nicht mehr als 1450°C, mehr bevorzugt nicht mehr als 1440°C, am meisten bevorzugt nicht mehr als 1435°C. In einer besonders bevorzugten Ausführungsform ist die Temperatur bei Ziehbeginn nicht weniger als 1420°C und nicht mehr als 1440°C.

Die Temperatur der Schmelze kann mit einer Messeinheit mit einer Genauigkeit von 0,1°C gemessen werden. Dabei wird vorzugsweise die Temperatur an der Oberfläche der Siliziumschmelze gemessen. Die Messeinheit zur Messung der Temperatur an der Oberfläche der Siliziumschmelze ist vorzugsweise ein Pyrometer. Die Temperatur der Siliziumschmelze an einem bestimmten Messpunkt kann mit einer Genauigkeit von 0,1°C gemessen und mit einer Genauigkeit von 1,0°C geregelt werden. Die Regelung der Temperatur der Schmelze kann über ein oder mehrere Heizelemente erfolgen, vorzugsweise eine oder mehrere Widerstandsheizungen, die um den Tiegel herum angeordnet sind. Die Heizelemente werden über eine programmierbare Steuereinheit gesteuert, die mit der Messeinheit verbunden ist und die Temperatur an der Oberfläche der Siliziumschmelze am Messpunkt in Abhängigkeit von der gemessenen Temperatur mit einer Genauigkeit von 1,0°C regelt.

Gemäß dem zweiten Aspekt der vorliegenden Erfindung können Scheiben aus Halbleitermaterial hergestellt werden, indem im Anschluss an das Verfahren zum Ziehen eines Einkristallstabs gemäß dem ersten Aspekt die folgenden Schritte durchgeführt werden: Schleifen des Einkristallstabs; Sägen des geschliffenen Einkristallstabs in Scheiben; Schleifen und/oder Läppen der Scheiben; Polieren der Scheiben; und chemisches Reinigen der Scheiben. Nach dem Abschluss des Ziehens kann der Kristallstab also, in dieser Reihenfolge, in Stücke gesägt und geschliffen, in Scheiben gesägt, die Scheiben anschließend geschliffen oder geläppt, poliert, chemisch gereinigt und so Scheiben aus Halbleitermaterial erhalten werden. Optional kann auf den so erhaltenen Scheiben eine epitaktische Schicht aus Halbleitermaterial abgeschieden werden. Die Abscheidung erfolgt vorzugsweise aus der Gasphase mittels CVD. Vorzugsweise besteht die epitaktische Schicht aus Halbleitermaterial aus, optional dotiertem, Silizium, Germanium, Siliziumcarbid oder Galliumnitrid.

Die polierten Scheiben können dann auf Versetzungen untersucht werden, wobei der Effekt der spannungsinduzierten Doppelbrechung genutzt wird. Dieser Effekt beruht darauf, dass Versetzungen und Defekte Spannungsfelder erzeugen. Wird ein Material Scherspannungen ausgesetzt, so wird sein Brechungsindex anisotrop und das Material doppelbrechend. Einfallendes linear polarisiertes Licht wird somit in Transmission oder Reflexion durch die Probe depolarisiert. Folglich sind die erhaltenen Depolarisationsverteilungen als Scherspannungsverteilungen interpretierbar.

Beispielsweise können die polierten Scheiben mittels SIRD (Scanning InfraRed Depolarization) vermessen werden. Die SIRD-Messung erfolgt mittels eines Transmissions-Dunkelfeld-Polariskops. Dabei durchstrahlt ein fest positionierter, linear polarisierter Lichtstrahl, vorzugsweise eine Laserstrahl, die zu untersuchende Scheibe aus Halbleitermaterial, die für die Messung auf einem Rotationtisch platziert, rotiert und kontinuierlich in radialer Richtung verschoben wird. Ist die Kristallstruktur der Scheibe versetzungs- und spannungsfrei, ändert sich die Polarisation des Lichtstrahls nicht. Liegen aber Versetzungen vor, erfährt der Lichtstrahl eine lokale Depolarisation, die durch spannungsinduzierte Doppelbrechung verursacht wird.

Zur Untersuchung der mit Hilfe des erfindungsgemäßen Verfahrens hergestellten Halbleiterscheiben auf zentrumsnahe Defekte/Versetzungen kann beispielsweise ein Messgerät des Typs PSI des Herstellers Semilab oder ein Gerät des Herstellers PVA Metrology & Plasma Solutions verwendet werden. Die laterale Auflösung einer solchen Messung liegt üblicherweise im Bereich von 50 bis 100 µm. Die Bestimmung der ortsabhängigen Depolarisation und Transmission in einer Scheibe gemäß dem dritten Aspekt der vorliegenden Erfindung erfolgt also mit einer lateralen Auflösung von mindestens 100 µm, vorzugsweise 50 µm.

Mittels dieser Messung kann eine gemäß dem zweiten Aspekt der vorliegenden Erfindung hergestellte Scheibe aus Halbleitermaterial, insbesondere eine Scheibe aus einkristallinem Silizium mit einem Durchmesser von 300 mm und einer <110>-Kristallorientierung, auf Versetzungen untersucht und so festgestellt werden, ob die Scheibe frei von zentrumsnahen Defekten ist.

Die Scheibe aus einkristallinem Silizium gemäß dem dritten Aspekt der vorliegenden Erfindung hat einen Nenndurchmesser von 300 mm und die Kristallorientierung ihrer Hauptflächen weicht nicht mehr als 5° von der Orientierung <110> ab. Die Scheibe kann optional Dotierstoffe enthalten, wobei die Dotierstoffkonzentration vorzugsweise weniger als 10¹⁵ Atomen pro cm³ beträgt. Die Dotierstoffkonzentration entspricht der Summe der Konzentrationen der Dotierstoffe B, Al, Ga, In, C, Ge, Sn, Pb, N, P, As, Sb, Bi und O.

Die Scheibe gemäß dem dritten Aspekt weist keine Versetzungen im Umkreis von 50 mm um den Scheibenmittelpunkt herum auf und ist damit frei von zentrumsnahen Defekten. Die Untersuchung der Scheibe auf Versetzungen erfolgt gemäß der folgenden Methode:
Platzieren der glanzgeätzten oder polierten Scheibe auf einem Rotationstisch in einem Transmissions-Dunkelfeld-Polariskop,
Versetzten der Scheibe auf dem Rotationstisch in Rotation,
Durchstrahlen der rotierenden Halbleiterscheibe auf dem Rotationstisch mit einem linear polarisierten Infrarot-Lichtstrahl, vorzugsweise einem Infrarot-Laserstrahl, während die Halbleiterscheibe kontinuierlich oder diskontinuierlich in radialer Richtung verschoben wird,
Bestimmung der ortsabhängigen Depolarisation und Transmission, und
Identifizierung der Stellen, an denen der Lichtstrahl depolarisiert wird als Versetzungen. Die laterale Auflösung der ortsabhängigen Depolarisation und Transmission liegt vorzugsweise im Bereich von 50 bis 100 µm.

Die Scheibe aus einkristallinem Silizium gemäß dem dritten Aspekt der vorliegenden Erfindung kann durch das erfindungsgemäße Verfahren gemäß dem zweiten Aspekt hergestellt werden. Eine <110>-Kristallorientierung im Sinne des dritten Aspekts der vorliegenden Erfindung liegt dann vor, wenn die Orientierung der Hauptflächen der Scheibe nicht mehr als 5°, vorzugsweise nicht mehr als 2°, besonders bevorzugt nicht mehr als 1,5°, von der <110>-Kristallorientierung abweicht. Somit kann die Orientierung der Hauptfläche der Vorder- und Rückseite der Scheibe gemäß dem dritten Aspekt der vorliegenden Erfindung bis zu 5°, vorzugsweise nicht mehr als 3°, von der Orientierung der Kristallebene mit dem Miller'schen Index (110) abweichen.

### Detaillierte Beschreibung von erfindungsgemäßen Ausführungsbeispielen und von Vergleichsbeispielen

In den Ausführungsbeispielen wurde jeweils ein zylindrischer Impfkristall aus einkristallinem Silizium mit einer <110>-Kristallorientierung und einem Durchmesser von 19 mm verwendet, um einen Kristallstab mit <110>-Orientierung gemäß der Czochralski-Methode zu ziehen. Der Impfkristall wurde an der Ziehwelle einer Kristallziehanlage des Typs EKZ 3000 des Herstellers PVA TePla befestigt. Ein mit festem, hochreinen Polysilizium des Herstellers Wacker Chemie gefüllter Quarztiegel wurde in der Kristallziehanlage zwischen einer Widerstandsheizung angeordnet. Nach dem Schließen, Spülen und Evakuieren der Kristallziehanlage wurde der Quarztiegel mit dem Silizium erhitzt und so eine Siliziumschmelze bereitgestellt. Die verwendete Kristallziehanlage umfasste außerdem ein Kamerasystem zum Beobachten einer Phasengrenze sowie ein Pyrometer zur Bestimmung der Temperatur der Schmelze. Die genaue Position und Form des Impfkristalls relativ zur Schmelze sowie die Form des wachsenden Kristallstabs, insbesondere des Impflingskonus, konnte somit mit dem Kamerasystem bestimmt werden.

Der Impfkristall wurde dann mit einer Geschwindigkeit von 10 mm/min nach unten bewegt, bis ein Teil des Impflings in die Schmelze eingetaucht war. Dann wurde der Impfkristall langsam unter Rotation nach oben bewegt und so zunächst ein Impflingskonus mit einer Länge von 175 mm bis 200 mm, einem oberen Durchmesser von 19 mm und einem unteren Durchmesser von 5 mm gezogen, indem die Zieh- und Rotationsgeschwindigkeit entsprechend erhöht wurden. Im Anschluss wurde ein Dünnhals mit einem Durchmesser von 5 mm und einer Länge von 300 mm gezogen. Darauffolgend wurde ein Anfangskonus gezogen und der Durchmesser auf 310 mm erhöht.

Nach Erreichen eines Kristalldurchmessers von über 310 mm wurde ein zylindrischer Abschnitt mit einem annähernd konstanten Durchmesser gemäß der Czochralski-Methode gezogen. Die Ziehgeschwindigkeit betrug zu diesem Zeitpunkt ca. 4 mm/min und die Rotationsgeschwindigkeit des Kristalls betrug 10 Umdrehungen pro Minute. Abschließend wurde ein Endkonus mit abnehmendem Durchmesser gezogen.

Nach dem Abschluss des Ziehens des Kristallstabs wurde der fertige Kristallstab entnommen und in Scheiben mit einer Dicke von 900 µm gesägt. Aus diesen wurden dann Scheiben mit einem Durchmesser von 200 mm hergestellt und diese auf eine Dicke von 750 µm geschliffen und glanzgeätzt.

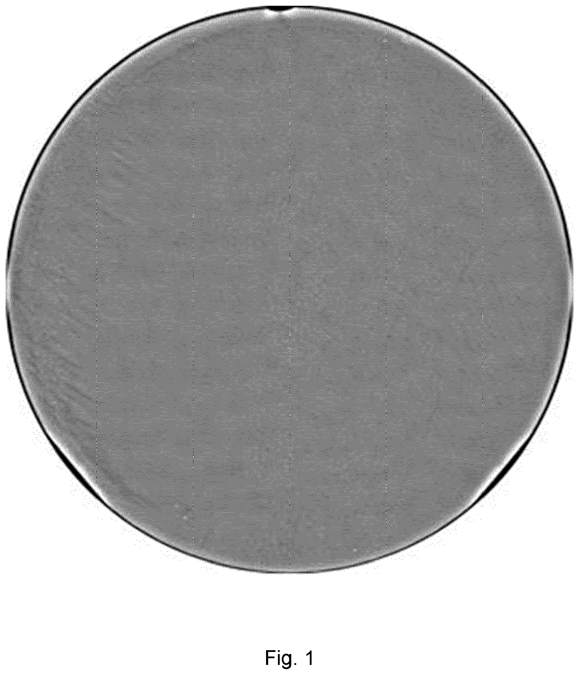

Diese Scheiben wurden dann auf Spannungen untersucht. Für die Untersuchung der Scheiben auf Spannungen wurde jeweils eine Scheibe auf einem Rotationstisch eines Messgerätes des Typs PSI des Herstellers Semilab platziert. Das Messgerät wies eine fest positionierte, linear polarisierte Infrarot-Lichtquelle und einen Rotationstisch auf. Die auf dem Rotationstisch rotierende Scheibe wurde während der Messung kontinuierlich in radialer Richtung verschoben, so dass die gesamte Oberfläche der Scheibe von der Lichtquelle abgetastet wurde. Es konnte gezeigt werden, dass die Scheiben keine Spannungen, insbesondere keine Spannungen im Umkreis von 50 mm um den Scheibenmittelpunkt herum, aufwies. Fig. 1 zeigt die mittels der Messung ermittelte Depolarisationsverteilungen der im Ausführungsbeispiel hegestellten Scheiben und zeigt, dass diese Scheiben frei von zentrumsnahen Defekten waren. Es wurden also im Ausführungsbeispiel defektfrei Scheiben aus einkristallinem Silizium mit einer <110>-Kristallorientierung ohne zentrumsnahe Defekte hergestellt.

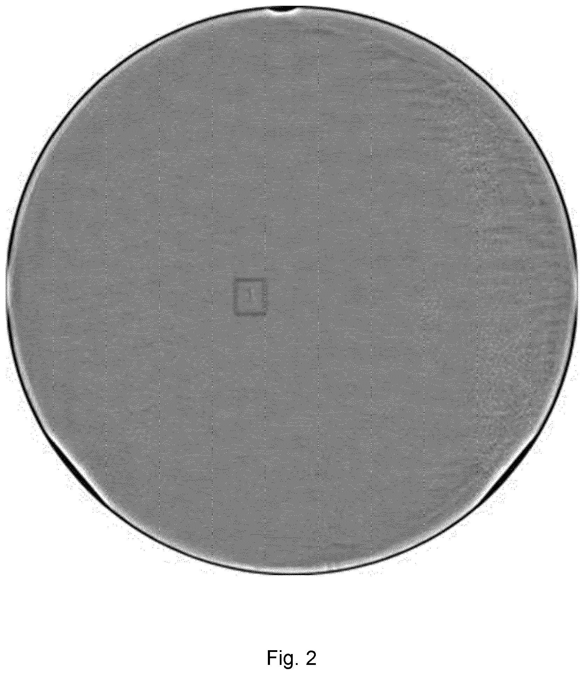

Das Vergleichsbeispiel unterscheidet sich nur dadurch von dem Verfahren der Ausführungsbeispiele, dass kein Impflingskonus mit einer Geometrie gemäß dem erfindungsgemäßen Verfahren gezogen wurde. Wie in den Ausführungsbeispielen wurde auch der im Vergleichsbeispiel hergestellte Kristallstab entnommen und in Scheiben mit einer Dicke von 900 µm gesägt. Aus diesen wurden dann Scheiben mit einem Durchmesser von 200 mm hergestellt und diese auf eine Dicke von 750 µm geschliffen und glanzgeätzt. Diese Scheiben wurden wie die in den Ausführungsbeispielen hergestellten Scheiben auf Spannungen untersucht. Fig. 2 zeigt die ermittelte Depolarisationsverteilung einer Scheiben aus einkristallinem Silizium, die im Vergleichsbeispiel hegestellt wurde. In Fig. 2 sind Spannungen im Zentrum der Scheiben zu erkennen. Es wurden also Spannungen und damit zentrumsnahe Defekte um den Scheibenmittelpunkt herum detektiert.

## Patentansprüche

1. Verfahren zum Ziehen eines Einkristallstabs aus einer Siliziumschmelze gemäß der Czochralski-Methode, umfassend die folgenden Schritte:
(i) Bereitstellen einer Siliziumschmelze und eines Impfkristalls aus einkristallinem Silizium über der Siliziumschmelze, wobei die Siliziumschmelze und/oder der Impfkristall optional Dotierstoffe umfassen;
(ii) Absenken des Impfkristalls, bis ein Kontakt zwischen dem Impfkristall und der Siliziumschmelze hergestellt ist; und
(iii) Ziehen eines Impflingskonus, eines Dünnhalses, eines Anfangskonus und eines zylindrischen Abschnitts des Einkristallstabs in dieser Reihenfolge durch Anheben des Impfkristalls;
**dadurch gekennzeichnet, dass** der Impflingskonus einen oberen Durchmesser von nicht weniger als 12 mm und nicht mehr als 22 mm, einen unteren Durchmesser von nicht weniger als 2 mm und nicht mehr als 10 mm, und eine axiale Länge von nicht weniger als 75 mm und nicht mehr als 300 mm aufweist.

2. Verfahren zum Ziehen eines Einkristallstabs gemäß dem Anspruch 1, wobei der Winkel zwischen einer Mantellinie des Impflingskonus und der Rotationsachse des Impflingskonus nicht weniger als 2° und nicht mehr als 15° beträgt.

3. Verfahren zum Ziehen eines Einkristallstabs gemäß einem der Ansprüche 1 und 2, wobei der Impflingskonus eine Länge von nicht weniger als 150 und nicht mehr 225 mm, einen oberen Durchmesser von nicht weniger als 14 und nicht mehr als 20 mm, und einen unteren Durchmesser von nicht weniger als 4 und nicht mehr als 6 mm hat.

4. Verfahren zum Ziehen eines Einkristallstabs gemäß einem der Ansprüche 1 bis 3, wobei der obere Durchmesser des Impflingskonus dem Durchmesser des Impfkristalls bevor ein Kontakt zwischen dem Impfkristalls und der Siliziumschmelze hergestellt wurde entspricht.

5. Verfahren zum Ziehen eines Einkristallstabs gemäß einem der Ansprüche 1 bis 4, wobei die Rotationsachse des Impflingskonus parallel zur Ziehrichtung verläuft.

6. Verfahren zum Ziehen eines Einkristallstabs gemäß einem der Ansprüche 1 bis 5, wobei der Impfkristall eine Kristallorientierung von <100>, eine Kristallorientierung von <110> oder eine Kristallorientierung von <111> aufweist.

7. Verfahren zum Ziehen eines Einkristallstabs aus Halbleitermaterial gemäß einem der Ansprüche 1 bis 6, wobei die Ziehrichtung nicht mehr als 3° von der Orientierung <110> abweicht.

8. Verfahren zum Ziehen eines Einkristallstabs aus Halbleitermaterial gemäß einem der Ansprüche 1 bis 7, wobei die Ziehrichtung nicht mehr als 2° von der Orientierung <110> abweicht.

9. Verfahren zum Ziehen eines Einkristallstabs gemäß einem der Ansprüche 1 bis 8, wobei der Impfkristall eine Dotierstoffkonzentration von weniger als 10¹⁵ Atomen pro cm³ aufweist.

10. Verfahren zum Ziehen eines Einkristallstabs gemäß dem Anspruch 9, wobei die Dotierstoffkonzentration die Summe der Konzentrationen der Dotierstoffe B, Al, Ga, In, C, Ge, Sn, Pb, N, P, As, Sb, Bi und O ist.

11. Verfahren zur Herstellung von Scheiben aus Halbleitermaterial, umfassend die folgenden Schritte:
Ziehen eines Einkristallstabs nach dem Verfahren gemäß einem der Ansprüche 1 bis 10,
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben.

12. Verfahren zur Herstellung von Scheiben aus Halbleitermaterial gemäß dem Anspruch 11, wobei das Verfahren zusätzlich den folgenden Schritt umfasst:
Abscheiden einer epitaktischen Schicht aus Halbleitermaterial auf der Scheibe aus Halbleitermaterial.

13. Scheibe aus einkristallinem Silizium, wobei die Scheibe einen Nenndurchmesser von 300 mm hat und die Kristallorientierung der Hauptflächen nicht mehr als 5° von der Orientierung <110> abweicht,
die Scheibe optional Dotierstoffe enthält, und
die Scheibe keine Versetzungen im Umkreis von 50 mm um den Scheibenmittelpunkt herum aufweist,
wobei die Untersuchung der Scheibe auf Versetzungen gemäß der folgenden Methode erfolgt:
Platzieren der glanzgeätzten oder polierten Scheibe auf einem Rotationstisch in einem Transmissions-Dunkelfeld-Polariskop,
Versetzen der Scheibe auf dem Rotationstisch in Rotation,
Durchstrahlen der rotierenden Halbleiterscheibe auf dem Rotationstisch mit einem linear polarisierten Infrarot-Lichtstrahl, während die Halbleiterscheibe kontinuierlich oder diskontinuierlich in radialer Richtung verschoben wird,
Bestimmung der ortsabhängigen Depolarisation und Transmission, und
Identifizierung der Stellen, an denen der Lichtstrahl depolarisiert wird als Versetzungen.
